Europäisches Patentamt

European Patent Office

Office européen des brevets

(19)

(11) Publication number: **0 023 708**
**B1**

# (12) EUROPEAN PATENT SPECIFICATION

(45) Date of publication of patent specification: **16.11.83**

(21) Application number: **80104545.1**

(22) Date of filing: **01.08.80**

(51) Int. Cl.³: **G 01 R 19/17,**
**G 01 R 13/06**

(54) **Overvoltage analyzer.**

(30) Priority: **02.08.79 IT 6859979**

(43) Date of publication of application:
**11.02.81 Bulletin 81/6**

(45) Publication of the grant of the patent:
**16.11.83 Bulletin 83/46**

(84) Designated Contracting States:
**DE FR GB**

(56) References cited:
**DE - A - 2 423 149**
**DE - A - 2 739 230**

(73) Proprietor: **CSELT Centro Studi e Laboratori**
**Telecomunicazioni S.p.A.**
**Via Guglielmo Reiss Romoli, 274**
**I-10148 Turin (IT)**

(72) Inventor: **Bollero, Adriano**
**Via M. Buonarroti, 7**
**Rivarolo Cans.se (TO) (IT)**
Inventor: **Carpinello, Bruno**
**Borgo Valentino**
**Arignano (Torino) (IT)**
Inventor: **Galliano, Giuseppe**
**Via Canonica 5/H**
**Torino (IT)**
Inventor: **Pomponi, Renato**
**c/o Ciocca Via Arno 50**
**Torino (IT)**

(74) Representative: **Riederer Freiherr von Paar zu**
**Schönau, Anton**
**Freyung 615 Postfach 2664**
**D-8300 Landshut (DE)**

Courier Press, Leamington Spa, England.

Overvoltage analyzer

The present invention relates to electronic instruments designed to measure and record electric magnitudes and more particularly it concerns an overvoltage analyzer.

The knowledge of the characteristics of overvoltages, induced on telecommunication installations in consequence of lightning or other pulse electrical phenomena, is necessary to adequately protect the installations and more particularly the equipment connected to them.

By means of measurements effected on the installations, the waveforms of overvoltages or the characteristics defining such voltages, for instance rise time, duration time and amplitude values, can be obtained.

The display of overvoltage waveform involves the use of a memory-oscilloscope and of an associated recording means (e.g. camera, paper recorder, etc...). This measurement method, obviously expensive due to the kind of instruments used, requires an external power supply, owing to the overall consumption, free from noise which otherwise could cause false readings on the recording means. That greatly reduces its versatility, in particular in use for measurements to be effected along the transmission line.

On the contrary the overvoltage analyzer according to the invention, offers directly information about the overvoltage characteristics, as to rise time, duration time and amplitude value of the voltage wave. Moreover due to its reduced dimensions and its autonomous power supply, this analyzer can easily be placed along the transmission line. As the cost is low a plurality of analyzers can be used to keep under observation a plurality of installations at the same time.

According to the invention, a circuit for analyzing and classifying overvoltages on a line with respect to amplitude, duration and rise time is characterised by:

— a measuring portion comprising: an input terminal coupled to the said line, comparator means comparing the voltage at the input terminal with a number of threshold values, the lowest of which defines the sensitivity threshold of the circuit, detector means adapted to detect the highest of the said threshold values which the said voltage exceeds, rise time counting means adapted to count the rise time the said voltage needs to increase from the sensitivity threshold value to the said highest threshold value which is exceeded by the said voltage, overvoltage duration detecting means adapted to determine the longest of a number of predetermined durations within which the said voltage exceeds the sensitivity threshold, combining circuit means adapted to provide numerical signals representing respective combinations of highest exceeded threshold value, rise time and overvoltage duration;

— a storage portion each memory location of which is addressed by one of the said numerical signals, said storage portion comprising incrementing means by which the contents of a memory location are incremented by one unit whenever this location is addressed;

— a display portion comprising manually controlled selector means for selecting the memory location the contents of which are to be displayed and an optical indicator (DI) to visualise said contents;

— a manually actuated memory erasing portion adapted to load the memory locations with the value "zero";

— a power supply portion consisting of an autonomous source of dc current.

These characteristics of the present invention will be come clearer from the following description of a preferred embodiment thereof, given by way of example and not in a limiting sense, taken in connection with the annexed drawing, showing a block diagram of the electric circuit of the overvoltage analyzer.

The overvoltage analyzer, which will be described hereinafter, analyzes positive and negative voltages and classifies them altogether in 32 classes, resulting from the combination of 4 ranges of amplitude values with 4 ranges of rise time values and with 4 ranges of duration time values. The range of amplitude values of an overvoltage presents extreme values that comprise the maximum value of the overvoltage itself. The rise time is the time interval between the crossing of a minimum level of sensitivity and the crossing of a maximum level, while duration time is the time interval between two successive crossings of the minimum sensitivity level, respectively in correspondance with the leading edge and the trailing edge of the overvoltage. Thirty-two different classes, each of them characterized by certain amplitude and rise or duration time values, are therefore obtained from these combinations, or correlations. If a better accuracy is required, the number of the classes can be increased by increasing the amplitude or time ranges according to requirements.

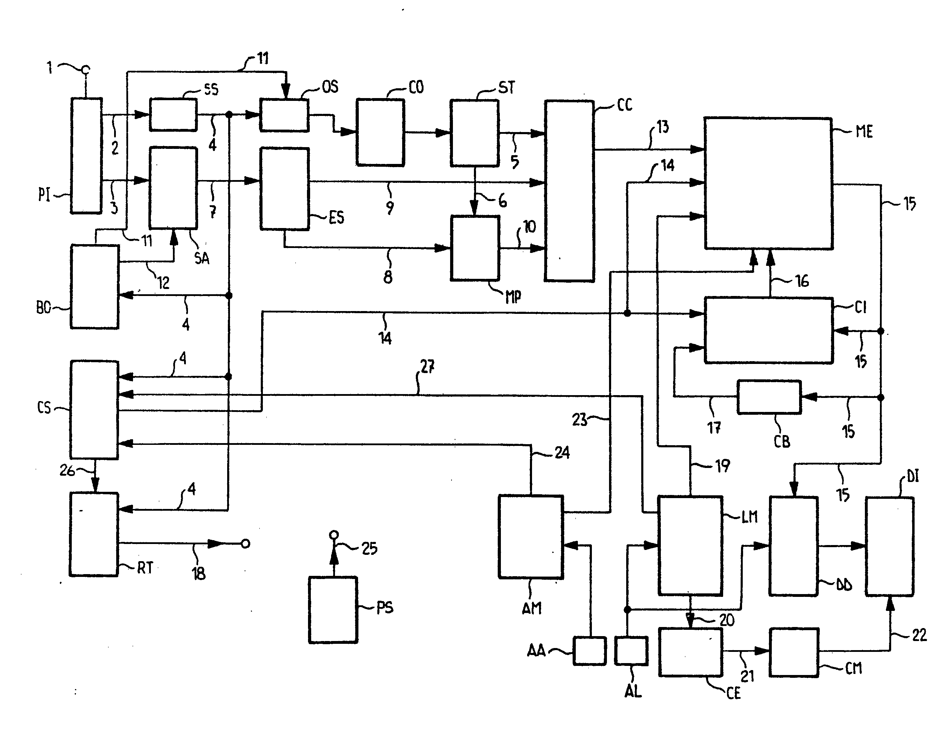

In the drawing, reference 1 denotes the input terminal, that can be connected to one of the wires forming the line under observation. Overvoltages are measured with respect to a connection to earth that is realized beginning from the common ground of the analyzer towards a connection to earth near the connection to the line.

By means of a capacitor, the voltages present at the input arrive directly or through an optical coupler at a voltage divider PI, having five outputs with different division ratios. The output with the lowest division ratio is connected through wire 2 to threshold comparator SS, that switches when on the line there is the voltage with the minimum amplitude considered, thus determining the instant of actuation of the other circuits. The sensitivity threshold of the analyzer is thus established, beneath which no signal is taken into consideration. The remaining four outputs of PI are connected through a four-wire connection denoted by 3 to a comparison circuit SA containing the same number of threshold comparators; each one of them switches when the voltage at the input of the divider PI exceeds a predetermined value, that can be defined as "amplitude threshold" in contrast to "sensitivity threshold".

The state change of the output of SS enables through wire 4 an oscillator OS, that supplies the clock signal to the whole analyzer. The pulses generated by OS arrive at a counter CO, that supplies at its output a binary number representative of the time which has elapsed from the moment when the sensitivity threshold has been exceeded. This number is compared in the next circuit ST with reference numbers through digital comparators. Then time thresholds can be established for the classification of overvoltages by means of these reference numbers. At the output of ST connected to wire 5 there is just the indication of the last time threshold that has been exceeded, while the intermediate thresholds are not taken into consideration.

When the overvoltage exceeds the lowest amplitude threshold, it causes a state change at the output of one of the threshold comparators contained in SA and therefore the corresponding signal is transferred through wire 7 at a circuit ES for the threshold exclusion. In this circuit there is a register that stores the information relating to the exceeded amplitude threshold as well as a circuit that recognizes that the threshold has been exceeded and sends the corresponding information through wire 8 to a circuit MP for the measurement of rise times.

The information on wire 8 is interpreted by MP, that basically consists of a shift register, as a signal enabling the transfer of the signal arriving on wire 6 from ST. This signal is representative of the time measured at this moment by ST, from which the rise time of the overvoltage is obtained. Once the successive thresholds have been exceeded this cycle is repeated, so that the information relating to the last exceeded amplitude threshold is stored in ES, and the information relating to the last measured rise time is stored in MP. Both of them are available on wires 9 and 10 respectively. When the voltage amplitude goes again below the sensitivity threshold, at the output of SS a state change takes place, that is sent on wire 4 to inhibition circuit BO. The latter inhibits oscillator OS by sending a suitable inhibition signal on wire 11, and as a consequence counter CO stops. At the output of ST, that is on wire 5, a data word is present relating to the last exceeded time threshold, that is to the total overvoltage duration. Circuit BO inhibits also the threshold comparators of SA by sending a suitable signal on wire 12. In this way the analyzer is not affected by any signal which could be present at its input immediately after the pulse damping.

Reference CC denotes a combinational circuit that receives at the inputs connected to wires 5 and 10 the information relating to duration and rise times and at the input connected to wire 9 the information relating to voltage amplitude. It combines each information on the times with the information on the amplitude, thus obtaining at the output connected to connection 13 two binary numbers, used to address two corresponding areas of a memory unit ME. This unit can consist either of solid state components or of electromechanical counters. The total number of the areas of ME is equal to the total number of the possible combinations of the data on times and amplitudes, that is to the total number of overvoltage classes: consequently, 32 memory areas are required in this embodiment.

Together with the inhibition of SA and OS, the signal of state change present on wire 4 arrives at a control circuit CS and causes it to emit on wire 14 towards ME a signal enabling the reading. Consequently the numbers stored in the areas addressed by CC arrive at the output connected to connection 15 and hence to the input of an increasing circuit CI. The latter increases by a unit each number and sends it back through connection 16 to the same areas of ME, where it is written again. The enabling to the writing and the increasing command are also supplied in sequence and in an automatic way by control circuit CS through wire 14. If the stored number reaches the maximum predetermined value, for instance 99, or 999, etc., further increment can be avoided by the use of a stopping circuit CB. This circuit, basically consisting of digital comparators, compares the number present on wire 15 to a reference number and in case of equality, it emits on wire 17 a signal preventing the increasing command, sent by CS on wire 14, from arriving at CI input.

This feature proves particularly useful when an overflow of the stored number is possible, that is when the number of overvoltages is higher than that estimated.

CS, once these operations are over, enables by means of a signal on wire 26 a resetting circuit RT, that senses whether on wire 4 there are signals exceeding the sensitivity threshold. If none is present, it immediately emits on wire 18 connected with most of the sequential circuits depicted in the drawing a resetting signal, so that the analyzer can return to the initial conditions and be ready to examine another overvoltage. On the contrary, every circuit is inhibited till SS is switched.

Reference AL denotes a manually controlled device that can enable the portion of circuits concerning the display of stored data. More particularly, an address generating circuit LM is actuated. This circuit is able to cyclically emit on connection 19 the whole sequence of binary numbers forming the 32 addresses of the areas of ME. At the same time, the control circuit CS emits in synchronism a reading pulse on wire 14, by drawing a timing signal on connection 27 from the circuit LM.

In such a way the contents of 32 memory areas cyclically appear at the output of ME. The addresses present on connection 19 are also present on connection 20 connected to a multiplexer CE, with an input kept at fixed voltage and 32 outputs. Each of these passes from logic zero to logic one whenever there is the corresponding address.

The 32 outputs of CE are connected by means of connection 21 to the fixed contacts of a manually controlled mechanical switch CM. On the mobile contact connected to wire 22 the voltage passes from logic zero to logic one whenever the address emitted by LM corresponds to the position number of switch CM. Device AL enables also a decoder DD able to convert binary numbers, coming from ME on wire 15 and representing the number of overvoltages of a specific class that have taken place to that instant, in the right code for the successive display device DI. This lightens only when it is enabled by the logic one coming from CM on wire 22, that is whenever the position selected on CM corresponds to the address emitted by circuit LM. If these addresses are made to occur one after the other at a rather high frequency, the number represented on the display device DI lightens and darkens thousands of times per second. Then, owing to the persistence of the image on the retina no flicker is perceived.

In the case in which it is interesting to read the data relating to the combination of an amplitude threshold with a duration time threshold contemporaneously with the data relating to the combination of the same amplitude threshold with a rise time threshold, two display devices and two decoders can be used, by dividing into two parts the memory so as to use a single address. During the data reading control circuit CS emits on wire 14 only reading pulses, that is why no new overvoltage present at the input of the analyzer is recorded.

If the contents of the memory unit ME are to be erased, reading circuits must be activated by AL and manually controlled device AA must be operated. In such a way a zeroing circuit AM is enabled, that sends by means of wire 23 a sequence of logic zeros to an input of ME. By means of wire 24 AM sends a writing request that sets CS to send a signal enabling to write in ME; in this manner logic zeros are stored in all the memory areas.

Finally reference PS denotes a battery of cells or of rechargeable accumulators.

## Claims

1. A circuit for analyzing and classifying overvoltages on a line with respect to amplitude, duration and rise time, characterized by

— a measuring portion comprising: an input terminal (1) coupled to the said line, comparator means (SS, SA) comparing the voltage at the input terminal (1) with a number of threshold values, the lowest of which defines the sensitivity threshold of the circuit, detector means (ES) adapted to detect the highest of the said threshold values which the said voltage exceeds, rise time counting means (OS, CO, ST, ES, MP) adapted to count the rise time the said voltage needs to increase from the sensitivity threshold value to the said highest threshold value which is exceeded by the said voltage, overvoltage duration detecting means (OS, CO, ST) adapted to determine the longest of a number of predetermined durations within which the said voltage exceeds the sensitivity threshold, combining circuit means (CC) adapted to provide numerical signals representing respective combinations of highest exceeded threshold value, rise time and overvoltage duration;

— a storage portion (ME, CI, CB) each memory location of which is addressed by one of the said numerical signals, said storage portion comprising incrementing means (CI) by which the contents of a memory location are incremented by one unit whenever this location is addressed;

— a display portion (AL, LM, CE; CM, DD, DI) comprising manually controlled selector means (AL, LM, CE, DD, CM) for selecting the memory location the contents of which are to be displayed and an optical indicator (DI) to visualise said contents;

— a manually actuated memory erasing portion (AA, AM) adapted to load the memory locations with the value "zero";

— a power supply portion (PS) consisting of an autonomous source of dc current.

2. Analyzer as in claim 1, characterized by a limiting portion (CB) limiting the contents of said memory locations to a maximum value.

3. Analyzer as in claim 1 or 2, characterized in that:

— a voltage divider (PI) is connected to the analyzer input terminal (1) and equipped with at least two outputs (2, 3) with different division ratios;

— the comparator means consists of a first threshold comparator (SS) connected to the output of said voltage divider (PI) with the lowest division ratio thereby comparing the voltage at this output with said sensitivity threshold, and of a comparison circuit (SA) basically consisting of one or of a plurality of second threshold comparators connected to the other output(s) of the voltage divider (PI) thereby comparing the voltage(s) at said other output(s) with said threshold values;

— an inhibition circuit (BO) emits inhibition signals when overvoltages at the input terminal (1) become again lower than the sensitivity threshold which inhibition signals inhibit the comparision circuit (SA);

— an oscillator (OS) for generating a periodic waveform is enabled by said first threshold comparator (SS) and inhibited by said inhibition circuit (BO), the periods of said oscillator being counted by a counter (CO);

— the overvoltage duration detecting means comprise a first threshold circuit (ST) for providing duration time thresholds, said first threshold circuit being connected to the counter (CO) and basically consisting of digital comparators able to emit suitable signals when the number of periods counted by the counter (CO) exceeds predetermined reference numbers;

— the detector means (ES) for the highest exceeded threshold value basically consists of a register adapted to store the information concerning the last threshold value that has been exceeded in the comparison circuit (SA) and of a circuit adapted to consequently emit a transfer command;

— the rise time counting means comprises a second threshold circuit (MP) for rise time thresholds, said second threshold circuit basically consisting of a shift register adapted to provide at its output (10) a binary signal arriving from said first threshold circuit (ST) upon a transfer command sent by the detector means (ES) for the highest threshold value;

— the combining circuit means (CC) are adapted to effect a first combination of the signals supplied by the first threshold circuit (ST) with the information stored in the detector means (ES) for the highest threshold value, and a second combination of the signals supplied by the second threshold circuit (MP) with the same threshold value stored in said detector means (ES);

— the storage portion comprises a memory unit (ME) addressed by the combining circuit means (CC) or by an address generating circuit (LM), the inputs for the data to be written into the memory unit being connected to the output (16) of the incrementing means (CI) and the output (23) of a zeroing circuit (AM), and the output (15) of the memory unit being connected to the input of said incrementing means (CI) and to the input of a decoder (DD), writing into or reading out of the memory unit being initiated by a control circuit (CS);

— the address generating circuit (LM) that can be started by a first manually controlled device (AL) is adapted to emit a sequence of binary numbers for addressing all the memory locations of said memory unit (ME) and for the stepping of a multiplexer (CE) having as many outputs as there are memory locations and an input kept at a fixed voltage value, the address generating circuit being further able to emit a sequence of timing signals synchronized with said sequence of binary numbers;

— the optical indicator (DI) can be actuated by a signal present at the mobile contact of a mechanical switch (CM) which can be manually operated from the outside and has said one mobile contact and has as many fixed contacts as there are memory locations in the memory unit (ME), each fixed contact being connected to one of the outputs of said multiplexer (CE);

— the decoder (DD) is adapted to decode the contents of each memory location to obtain a signal able to drive said optical indicator (DI) when the decoder is enabled by said first manually controlled device (AL);

— the memory locations of said memory unit (ME) can be made zero by the zeroing circuit (AM) that can be actuated by a second manually controlled device (AA) operable from the outside and is adapted to send a sequence of logic zeros to an input of the memory unit and a writing request to the control circuit (CS);

— a resetting circuit (RT) is adapted to send a resetting signal to the settable circuits to the analyzer when an enabling signal is sent by the control circuit (CS) and no overvoltages exceeding said sensitivity threshold are present at the input terminal (1); and

— the enabling signal for the resetting circuit (RT) is supplied by the control circuit (CS) which is also adapted to sequentially supply for each overvoltage a reading command and subsequently a writing command to said memory unit (ME) when the overvoltage at the input terminal becomes lower than the sensitivity threshold, an incrementing command to said incrementing means (CI) being provided between a reading command and the subsequent writing command and the resetting command to said resetting circuit (RT) being provided after said writing command, the control circuit being also adapted to sequentially supply, for each display step of the contents of the memory locations, said reading commands at a rhythm determined by the timing signals supplied by said address generating circuit (LM), and being, moreover, adapted to supply sequentially, for each step of zeroing of the contents of the memory locations, writing commands at a rhythm determined by said address generating circuit (LM).

4. Analyzer as in claim 3, characterized in that it comprises a stopping circuit (CB) adapted to compare at each incrementing command the contents of the addressed location of said memory unit (ME) with a predetermined number and to send to said incrementing means (CI) an inhibition signal every time it detects the equality between said contents and said predetermined number.

5. Analyzer as in any of claims 1 to 4, characterized in that said autonomous source (PS) of dc current is a rechargeable accumulator battery.

6. Analyzer as in any of claims 1 to 4, characterized in that said autonomous source (PS) of dc current is a cell battery.

## Patentansprüche

1. Schaltung zum Analysieren und Klassifizieren von Überspannungen auf einer Leitung in Bezug zu Amplitude, Dauer und Anstiegszeit, gekennzeichnet durch

— einen Meß-Teil mit: einer an die Leitung angeschlossenen Eingangsklemme (1), einer Komparatoreinrichtung (SS, SA), die die Spannung an der Eingangsklemme (1) mit einer Anzahl von Schwellenwerten vergleicht, von denen die unterste die Empfindlichkeitsschwelle der Schaltung bestimmt, einer Detektoreinrichtung (ES), die den höchsten der von der Spannung überschrittenen Schwellenwerte feststellt, einer Anstiegszeit-Zähleinrichtung (OS, CO, ST, ES, MP), die die von der Spannung zum Anwachsen von der Empfindlichkeitsschwelle zum höchsten Schwellenwert, der von dieser Spannung überschritten wird, benötigte Anstiegszeit zählt, einer Überspannungsdauer-Detektoreinrichtung (OS, CO, ST), die den längsten einer Anzahl von vorgegebenen Zeitdauerwerten, innerhalb derer die Spannung die Empfindlichkeitsschwelle überschreitet, ermittelt, und einer Verknüpfungsschaltung (CC), die numerische Signale abgibt, welche jeweilige Verknüpfungen des höchsten überschrittenen Schwellenwerts, der Anstiegszeit und der Überspannungsdauer angeben;
— enen Speicher-Teil (ME, CI, CD), dessen einzelne Speicherbereiche jeweils von einem der numerischen Signale adressiert werden und der eine Inkrement-Einrichtung (CI) enthält, durch die der Speicherinhalt eines Speicherbereichs jedesmal dann um eine Einheit erhöht wird, wenn dieser Bereich adressiert wird;
— einen Darstell-Teil (AL, LM, CE; CM, DD, DI) mit einer manuell gesteuerten Selektoreinrichtung (AL, LM, CE, DD, CM) zum Wählen des Speicherbereichs, dessen Inhalt dargestellt werden soll, und mit einem optischen Anzeiger (DI) zum Darstellen des Inhalts;
— einen manuell betätigten Speicherlösch-Teil (AA, AM), der in die Speicherbereiche den Wert "Null" lädt;
— und einen Stromversorgungs-Teil (PS), der aus einer autonomen Gleichstromquelle besteht.

2. Analysator nach Anspruch 1, gekennzeichnet durch einen Begrenzer-Teil (CB), der die Inhalte der Speicherbereiche auf einen Maximalwert begrenzt.

3. Analysator nach Anspruch 1 oder 2, dadurch gekennzeichnet, daß:

— ein Spannungsteiler (PI) mit der Eingangsklemme (1) des Analysators verbunden ist und über wenigstens zwei Ausgänge (2, 3) mit unterschiedlichem Teilungsverhältnis verfügt;
— die Komparator-Einrichtung aus einem ersten Schwellenkomparator (SS), der an denjenigen Ausgang des Spannungsteilers (PI) angeschlossen ist, der das niedrigste Teilungsverhältnis aufweist, und der hierdurch die Spannung an diesem Ausgang mit der Empfindlichkeitsschwelle vergleicht, und einer Komparatorschaltung (SA), die im wesentlichen aus einem oder einer Mehrzahl von zweiten Schwellenkomparatoren besteht, die mit dem anderen Ausgang/den anderen Ausgängen des Spannungsteilers (PI) verbunden ist/sind, und hierdurch die Spannung(en) an diesem anderen Ausgang/diesen anderen Ausgängen mit den Schwellenwerten vergleicht, besteht;
— eine Inhibitorschaltung (BO) dann, wenn Überspannungen an der Eingangsklemme (1) wieder niedriger als die Empfindlichkeitsschwelle werden, Sperrsignale abgibt, die die Komparatorschaltung (SA) sperren;
— ein Oszillator (OS), der ein periodisches Signal erzeugt und dessen Perioden von einem Zähler (CO) gezählt werden, vom ersten Schwellenkomparator (SS) aktiviert und von der Inhibitorschaltung (BO) gesperrt wird;
— die Überspannungsdauer-Detektoreinrichtung eine erste Schwellenschaltung (ST) zum Bereitstellen von Zeitdauerschwellen umfaßt, die an den Zähler (CO) angeschlossen ist und im wesentlichen aus Digitalkomparatoren besteht, die dann, wenn die vom Zähler (CO) gezählte Periodenzahl gegebene Bezugszahlen übersteigt, entsprechende Signale abgeben;
— die Detektoreinrichtung (ES) für den höchsten überschrittenen Schwellenwert im wesentlichen aus einem die Information über den letzten in der Komparatorschaltung (SA) überschrittenen Schwellenwert speichernden Register und aus einer als Folge hiervon einen Transferbefehl abgebenden Schaltung besteht;

— die Anstiegszeit-Zähleinrichtung eine zweite Schwellenschaltung (MP) für Anstiegszeitschwellen umfaßt, die im wesentlichen aus einem Schieberegister besteht, das auf einen von der Detektoreinrichtung (ES) für den höchsten Schwellenwert abgegebenen Befehl hin an seinem Ausgang (10) ein Binärsignal abgibt, das von der ersten Schwellenschaltung (ST) eintrifft;

— die Verknüpfungsschaltung (CC) eine erste Verknüpfung der von der ersten Schwellenschaltung (ST) gelieferten Signale mit der in der Detektoreinrichtung (ES) für den höchsten Schwellenwert gespeicherten Information bewirkt und eine zweite Verknüpfung der von der zweiten Schwellenschaltung (MP) gelieferten Signale mit dem selben in der Detektoreinrichtung (ES) gespeicherten Schwellenwert bewirkt;

— der Speicher-Teil eine Speichereinheit (ME) umfaßt, die von der Verknüpfungsschaltung (CC) oder von einer Adressengeneratorschaltung (LM) adressiert wird und deren Eingangsklemmen für die in die Speichereinheit zu schreibenden Daten mit dem Ausgang (16) der Inkrement-Einrichtung (CI) und dem Ausgang (23) einer Nullstellungsschaltung (AM) verbunden sind und deren Ausgang (15) mit dem Eingang der Inkrement-Einrichtung (CI) und mit dem Eingang eines Decoders (DD) verbunden ist, wobei durch eine Steuerschaltung (CS) das Schreiben in die oder Lesen aus der Speichereinheit gestartet wird;

— die Adressengeneratorschaltung (LM), die von einer ersten manuell gesteuerten Vorrichtung (AL) startbar ist, eine Folge binärer Zahlen zum Adressieren sämtlicher Speicherbereiche der Speichereinheit (ME) und zum Weiterstellen eines Multiplexers (CE), der so viele Ausgänge aufweist, als es Speicherbereiche gibt, und einen auf einem festen Spannungswert gehaltenen Eingang aufweist, abgibt und außerdem eine Folge von mit der Folge der binären Zahlen synchronisierten Zeitsteuersignalen abgibt;

— der optische Anzeiger (DI) durch ein am beweglichen Kontaktstück eines mechanischen Schalters (CM) liegendes Signal aktivierbar ist, der manuell von außen bedienbar ist und das eine bewegliche Kontaktstück und so viele feste Kontaktstücke aufweist, als Speicherbereiche in der Speichereinheit (ME) vorhanden sind, wobei jedes der festen Kontaktstücke mit einem der Ausgänge des Multiplexer (CE) verbunden ist;

— der Decoder (DD) die Inhalte jedes Speicherbereichs zum Erhalten eines Signals decodiert, das den optischen Anzeiger (DI) treibt, wenn der Decoder von der ersten manuell gesteuerten Vorrichtung (AL) angesteuert ist;

— die Speicherbereiche der Speichereinheit (ME) durch die Nullstellungsschaltung (AM), die durch eine zweite manuell gesteuerte Vorrichtung (AA), die von außen betätigbar ist, aktivierbar ist und eine Folge von booleschen Nullen an den Eingang der Speichereinheit und eine Schreibanforderung an die Steuerschaltung (CS) sendet, auf Null stellbar sind;

— eine Rückstellschaltung (RT) an die einstellbaren Schaltungen des Analysators ein Rückstellsignal sendet, wenn von der Steuerschaltung (CS) ein Ansteuersignal gesendet wird und an der Eingangsklemme (1) keine die Empfindlichkeitsschwelle überschreitenden Überspannungen anliegen; und

— das Ansteuersignal für die Rückstellschaltung (RT) von der Steuerschaltung (CS) geliefert wird, die auch für jede Überspannung sequentiell einen Lesebefehl und anschließend einen Schreibbefehl an die Speichereinheit (ME) liefert, wenn die Überspannung an der Eingangsklemme niedriger als die Empfindlichkeitsschwelle wird, ein Erhöhungsbefehl an die Inkrement-Einrichtung (CI) zwischen dem einzelnen Lese- und anschließenden Schreibbefehl und der Rückstellbefehl an die Rückstellschaltung (RT) nach dem Schreibbefehl ergeht, die Steuerschaltung außerdem aufeinanderfolgend für jeden Schritt des Anzeugens des Inhalts der Speicherbereiche die Lesebefehle in einer Folge sendet, die von den von der Adressengeneratorschaltung (LM) gelieferten Zeitsteuersignalen bestimmt ist, und schließlich außerdem aufeinanderfolgend für jeden Schritt des Nullstellens des Inhalts der Speicherbereiche Schreibbefehle in einer Folge sendet, die durch die Adressengeneratorschaltung (LM) bestimmt wird.  ·

4. Analysator nach Anspruch 3, dadurch gekennzeichnet, daß er eine Anhalteschaltung (CB) umfaßt, die bei jedem Erhöhungsbefehl die Inhalte des adressierten Speicherbereichs der Speichereinheit (ME) mit einer gegebenen Zahl vergleicht und an die Erhöhungs-Schaltung (CI) dann ein Sperrsignal abgibt, wenn sie feststellt, daß die Inhalte und die vorgegebene Zahl gleich sind.

5. Analysator nach einem der Ansprüche 1 bis 4, dadurch gekennzeichnet, daß die autonome Gleichstromquelle (PS) eine wiederaufladbare Akkumulatorbatterie ist.

6. Analysator nach einem der Ansprüche 1 bis 4, dadurch gekennzeichnet, daß die autonome Gleichstromquelle (PS) eine Zellenbatterie ist.

**Revendications**

1. Circuit pour analyser et classifier des tensions impulsives sur une ligne selon l'amplitude, la durée et le temps de montée, caractérisé par:

— une partie réservée à la mesure, qui comprend:

— des bornes d'entrés (1), connectées à ladite ligne,

— un moyen de comparaison (SS, SA) pour comparer la tension aux bornes d'entrée (1) à plusieurs valeurs de seuil, dont la mineure a la fonction de seuil de sensibilité du circuit,

— un moyen de détection (ES), apte à détecter la valeur de seuil la plus élevée qui a été dépassée par ladite tension,

— un moyen de comptage du temps de montée (OS, CO, ST, ES, MP), apte à compter le temps de montée qui ladite tension met à passer de la valeur de seuil de sensibilité à ladite valeur de seuil la plus elevée, qui est dépassée par ladite tension,

— des moyens de détection de la durée des tensions impulsives (OS, CO, ST), aptes à détecter la durée la plus longue d'une pluralité de durées prédéterminées, dans lesquelles ladite tension dépasse le seuil de sensibilité,

— un circuit de combinaison (CC), apte à founir des signaux numériques qui représentent respectivement les combinaisons de la valeur de seuil la plus élevée, qui a été dépassée, du temps de montée et de la durée de la tension impulsive;

— une partie réservée à la mémorisation (ME, CI, CB), dont chaque zone de mémoire est adressée par un desdits signaux numériques, ladite partie réservée à la mémorisation comprenant des moyens d'incrémentation qui augmentent d'une unité le contenu d'une zone de mémoire toutes les fois que cette zone est adressée;

— une partie destinée à l'affichage (AL, LM, GE; CM, DD, DI), qui comprend des moyens de commande manuelle (AL, LM, CE, DD, CM) pour sélectionner les zones de mémoires dont les contenus doivent être représentés et un indicateur optique (DI) pour représenter lesdits contenus;

— une partie réservée à l'effacement du contenu desdites zones de mémoire (AA, AM) activée par suite d'une commande manuelle, où ledit contenu est remplacé par une séquence de zéros logiques;

— une partie réservée à l'alimentation (PS) constituée par une source autonome de courant continu.

2. Analyseur selon la revendication 1, caractérisé en ce qu'il comprend une partie (CB) réservée à la limitation à une valeur maximale du contenu desdites zones de mémoire.

3. Analyseur selon l'une des revendications 1 ou 2 caractérisé en ce que:

— un diviser de tension (PI) est connecté aux bornes d'entrée (1) de l'analyseur et est équipé d'au moins deux sorties (2, 3) avec différents rapports de division;

— le moyen de comparaison est constitué par un premier comparateur de seuil (SS) connecté à la sortie ayant le rapport de division le plus bas dudit diviseur de tension (PI) pour comparer la tension à cette sortie avec ledit seuil de sensibilité et par un circuit de comparaison (SA), essentiellement constitué par un ou plusieurs deuxièmes comparateurs de seuil connectés avec l'autre au les autres sorties dudit diviseur de tension (PI) pour comparer la tension ou les tensions auxdites autres sorties avec lesdited valeurs de seuil;

— un circuit de blocage (BO) émet des signaux qui ont la signification d'inhibition lorsque les tensions impulsives aux bornes d'entrées (1) descendent au-dessous de ce seuil de sensibilité, ces signaux d'inhibition bloquant le circuit de comparaison (SA);

— un oscillateur (OS), capable de produire une forme d'onde périodique, est validé par ce premier comparateur de seuil (SS) et est inhibé par ce circuit de blocage (BO), les périodes dudit oscillateur étant comptées par un compteur (CO);

— les moyens de détection de la durée des tensions impulsives comprennent un premier circuit à seuil (ST) pour fournir des seuils de durée temporelle, ledit premier circuit à seuil étant connecté à ce compteur (CO) et constitué essentiellement par comparateurs numériques qui peuvent émettre des signaux convenables lorsque le nombre des périodes comptées par ce compteur (CO) excède les nombres de référence prédéterminés;

— le moyen de détection (ES) pour la valeur de seuil la plus élevée qui a été dépassée est constitué essentiellement par un registre capable de mémoriser l'information relative au dernier seuil d'amplitude, qui a été dépassé dans ce circuit de comparaison (SA), et par un circuit capable d'émettre en conséquence une commande de déplacement;

— le moyen de comptage du temps de montée comprend un second circuit à seuil (MP) pour seuils de temps de montée ledit second circuit à seuil étant constitué essentiellement par un registre de déplacement capable de fournir à sa sortie (10) un signal binaire qu'il reçoit dudit premier circuit à seuil (ST), en raison de la commande de transfert envoyée par le moyen de détection (ES) pour la valeur de seuil la plus élevée;

— le circuit de combinaison (CC) est apte à effectuer une première combinaison des signaux envoyés par le premier circuit à seuil (ST) avec l'information mémorisée dans le moyen de détection (ES) pour la valeur de seuil la plus élevée et une seconde combinaison des signaux envoyés par le second circuit à seuil (MP) avec la même valeur de seuil memorisée dans ledit moyen de détection (ES);

— la partie réservée à la mémorisation comprend un dispositif de mémoire (ME), adressé par ledit circuit de combinaison (CC) ou par un circuit générateur d'adresses (LM), les entrées pour les données à écrire dans le dispositif de mémoire étant connectées à la sortie (16) du moyen d'incrémentation (CI) et à la sortie (23) d'un circuit de mise à zéro (AM), et la sortie (15) du dispositif de mémoire étant connectée à l'entrée dudit moyen d'incrémentation (CI) et à l'entrée d'un décodeur (DD), l'écriture ou la lecture du dispositif de mémoire étant validées par un circuit de commande (CS);

— le circuit générateur d'adresses (LM) qui peut être validé par un premier dispositif de commande manuelle (AL) est capable d'émettre une séquence de nombres binaires pour adresser toutes les zones dudit dispositif de mémoire (ME) et pour avancer un multiplexeur (CE), ayant autant de sorties que des zones de mémoire et l'entrée qui est maintenue à une valeur fixe de tension, le circuit générateur d'adresses étant en outre capable d'émettre une séquence de signaux d'horloge synchronisée avec cette séquence de nombre binaires;

— l'indicateur optique (DI) peut être validé par un signal présent sur le contact mobile dudit commutateur mécanique (CM), qui peut être actionné manuellement de l'extérieur et a ladit contact mobile et autant de contacts fixes que des zones dudit dispositif de mémoire (ME), chaque contact fixe étant connecté à une des sorties de ce multiplexeur (CE);

— le décodeur (DD) est capable de décoder le contenu de chaque zone de mémoire pour obtenir un signal capable de piloter cet indicateur optique (DI), lorsque le décodeur est validé par ce premier dispositif de commande manuelle (AL);

— les zones de mémoire dudit dispositif de mémoire (ME) peuvent être mises à zéro par le circuit de mise à zéro (AM), qui est validé par un second dispositif de commande manuelle (AA), actionné de l'extérieur et est capable d'envoyer une séquence de zéros logiques à une entrés dudit dispositif de mémoire et un signal de demande d'écriture au circuit de commande (CS);

— un circuit de remise à zéro (RT) est capable d'envoyer un signal de remise à zéro aux circuits positionnables de l'analyseur, lorsqu'un signal de validation est envoyé par le circuit de commande (CS) et il n'y a pas des tensions excédant ce seuil de sensibilité aux bornes d'entrée (1); et

— le signal de validation pour le circuit de remise à zéro (RT) est fourni par le circuit de commande (CS) qui est en outre capable d'envoyer séquentiellement pour chaque tension impulsive une commande de lecture et après d'écriture audit dispositif de mémoire (ME), lorsque la tension impulsive aux bornes d'entrée descend au-dessous du seuil de sensibilité, une commande d'incrémentation à ce circuit d'incrémentation (CI) étant fournie entre une commande de lecture et la successive commande d'écriture et la commande de remise à zéro audit circuit de remise à zéro (RT) étant fournie après cette commande d'écriture, le circuit de commande étant capable aussi de fournir séquentiellement, pour chaque phase d'affichage du contenu des zones de mémoire, encore ces commandes de lecture selon un rythme déterminé par les signaux d'horloge produits par ce circuit générateur d'adresse (LM), et étant enfin capable de fournir séquentiellement pour chaque phase de remise à zéro du contenu des zones de mémoire, des ordres d'écriture à un rythme déterminé par ce circuit générateur d'adresses (LM).

4. Analyseur selon la revendication 3, caractérisé en ce qu'il comprend un circuit d'arrêt (CB), capable de comparer à chaque commande d'incrémentation le contenu d'une zone adressée du dispositif de mémoire (ME) avec un nombre prédéterminé et d'envoyer audit circuit d'incrémentation (CI) un signal d'inhibition chaque fois qu'il détecte l'égalité de ce contenu avec ce nombre prédéterminé.

5. Analyseur selon l'une quelconque des revendications 1 à 4, caractérisé en ce que ladite source autonome de courant continu (PS) est une batterie d'accumulateurs rechargeables.

6. Analyseur selon l'une quelconque des revendications 1 à 4, caractérisé en ce que ladite source autonome de courant continu (PS) est une batterie de piles.